# EUROPEAN PATENT APPLICATION

(11) **EP 4 753 414 A1**
(43) Date of publication of application: **03.06.2026**
(21) Application number: 25186554.9
(22) Date of filing: 01.07.2025
(51) Int. Cl.: H10H 29/14, H10H 29/39, H10H 29/80

(54) **DISPLAY APPARATUS**

(30) Priority: 29.11.2024 KR 20240175151
(71) Applicant: Samsung Electronics Co., Ltd., Suwon-si, Gyeonggi-do 16677 (KR)
(72) Inventor: SIM, Jaein, 16677 Suwon-si, Gyeonggi-do (KR); KIL, Junghwan, 16677 Suwon-si, Gyeonggi-do (KR); KIM, Inhyuk, 16677 Suwon-si, Gyeonggi-do (KR); LEE, Gyeongmi, 16677 Suwon-si, Gyeonggi-do (KR); LEE, Donghyeong, 16677 Suwon-si, Gyeonggi-do (KR); JEON, Joonwoo, 16677 Suwon-si, Gyeonggi-do (KR)
(74) Representative: Kuhnen & Wacker Patent- und Rechtsanwaltsbüro PartG mbB

(57) **Abstract**

A display apparatus (10) includes a pixel array (100). The pixel array (100) may include a plurality of light emitting diode, LED, cells respectively including a first conductivity-type semiconductor layer, an active layer, a second conductivity-type semiconductor layer, and a transparent electrode that includes a first lower surface and a second lower surface being offset from the first lower surface to form a step. The pixel array (100) may further include a cover electrode on the first lower surface of the transparent electrode of the plurality of LED cells, a capping layer covering a lower surface of the cover electrode and the second lower surface of the transparent electrode, a reflective electrode extending at least on a side surface of the plurality of LED cells, and connection electrodes connected to the cover electrode on the plurality of LED cells through a contact hole of the capping layer.

## Description

### BACKGROUND

One or more embodiments of the present disclosure relate to a display apparatus including a micro light-emitting diode (LED).

Semiconductor LEDs have been used not only as light sources for lighting systems, but also as light sources in various electronic devices. In particular, LEDs have been widely used as light sources in various display apparatuses such as televisions, mobile phones, personal computers (PCs), laptop computers, personal digital assistants (PDAs), and the like.

Display apparatuses in the related art may include a display panel including a liquid crystal display (LCD) and a backlight. However, recent advancements have led to the development of display apparatuses that use LEDs as pixels, without the need for a separate backlight. Such display apparatuses may offer the advantages of miniaturization, high-luminance, and excellent light efficiency, compared to conventional LCDs.

### SUMMARY

One or more embodiments of the present disclosure provide a display apparatus having light emitting efficiency.

According to an aspect of the present disclosure, a display apparatus may include a pixel array. The pixel array may include: a plurality of light emitting diode (LED) cells respectively including a first conductivity-type semiconductor layer, an active layer, a second conductivity-type semiconductor layer, and a transparent electrode that includes a first lower surface and a second lower surface being offset from the first lower surface to form a step; a cover electrode on the first lower surface of the transparent electrode of the plurality of LED cells; a capping layer covering a lower surface of the cover electrode and the second lower surface of the transparent electrode; a reflective electrode extending at least on a side surface of the plurality of LED cells; and connection electrodes connected to the cover electrode on the plurality of LED cells through a contact hole of the capping layer.

According to an aspect of the present disclosure, a display apparatus may include a pixel array. The pixel array may include: a plurality of light emitting diode (LED) cells including a first conductivity-type semiconductor layer, an active layer, a second conductivity-type semiconductor layer, and a contact electrode; a cover electrode in contact with a first lower surface of the contact electrode of the plurality of LED cells; a first capping layer covering the cover electrode; a second capping layer in contact with a second lower surface of the contact electrode, a side surface of the first capping layer, and a side surface of the cover electrode; a reflective electrode extending at least on a side surface of the plurality of LED cells; and connection electrodes connected to a connecting region of a lower surface of the cover electrode through a contact hole of the first capping layer, wherein an area of the first lower surface of the contact electrode is greater than an area of the second lower surface of the contact electrode and an area of the connecting region of the cover electrode.

According to an aspect of the present disclosure, a display apparatus may include a pixel array. The pixel array may include: a plurality of light emitting diode (LED) cells including a first conductivity-type semiconductor layer, an active layer, a second conductivity-type semiconductor layer, and a contact electrode; a cover electrode on a lower surface of the contact electrode of the plurality of LED cells; a capping layer covering at least a portion of each of the cover electrode and the contact electrode; a reflective electrode extending at least on a side surface of the plurality of LED cells; and connection electrodes connected to the lower surface of the cover electrode through a contact hole of the capping layer. The contact electrode may include a central portion overlapping the cover electrode in a vertical direction, and a peripheral portion defining a groove region around the central portion. The capping layer fills the groove region.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic perspective view of a display apparatus according to one or more example embodiments of the present disclosure;
FIG. 2 is a partially enlarged plan view of portion "A" of the display apparatus in FIG. 1;
FIG. 3 is a schematic cross-sectional view of a display apparatus according to one or more example embodiments of the present disclosure;
FIG. 4A is a partially enlarged cross-sectional view of portion "B" of the display apparatus in FIG. 3, and FIG. 4B is a schematic bottom view of a contact electrode according to one or more example embodiments;
FIG. 5 is a driving circuit implemented in a display apparatus according to one or more example embodiments of the present disclosure;
FIG. 6 is a schematic cross-sectional view of a display apparatus according to one or more example embodiments of the present disclosure;
FIG. 7 is a partially enlarged cross-sectional view of portion "B1" of the display apparatus in FIG. 6;
FIG. 8 is a schematic cross-sectional view of a display apparatus according to one or more example embodiments of the present disclosure;
FIG. 9 is a partially enlarged cross-sectional view of portion "B2" of the display apparatus in FIG. 8;
FIG. 10 is a schematic cross-sectional view of a display apparatus according to one or more example embodiments of the present disclosure;
FIG. 11 is a partially enlarged cross-sectional view of portion "B3" of the display apparatus in FIG. 10;
FIG. 12 is a schematic cross-sectional view of a display apparatus according to one or more example embodiments of the present disclosure;
FIG. 13 is a partially enlarged cross-sectional view of portion "B4" of the display apparatus in FIG. 12;
FIGS. 14A to 14I are cross-sectional views of main processes in a method of manufacturing a display apparatus according to one or more example embodiments of the present disclosure;
FIGS. 15A to 15L are cross-sectional views of main processes in a method of manufacturing of a display apparatus according to one or more example embodiments of the present disclosure;
FIGS. 16A to 16C are cross-sectional views of main processes in a method of manufacturing of a display apparatus according to one or more example embodiments of the present disclosure; and
FIG. 17 is a schematic diagram of an electronic device including a display apparatus according to one or more example embodiments of the present disclosure.

### DETAILED DESCRIPTION

Hereinafter, preferred example embodiments will be described in detail. Unless otherwise described, the terms such as "upper," "upper portion," "upper surface," "lower," "lower portion," "lower surface," and "side surface" are based on the drawings, and may vary depending on a direction in which a component is actually arranged.

In addition, ordinal numbers such as "first," "second," "third," and the like may be used as labels for specific elements, operations, directions, and the like, to distinguish various elements, steps, directions, and the like from one another. A term, not described in the specification using "first," "second," and the like, may still be referred to as "first" or "second" in the claims. In addition, a term referenced by a particular ordinal number (for example, "first" in a particular claim) may be described elsewhere with a different ordinal number (for example, "second" in the specification or another claim).

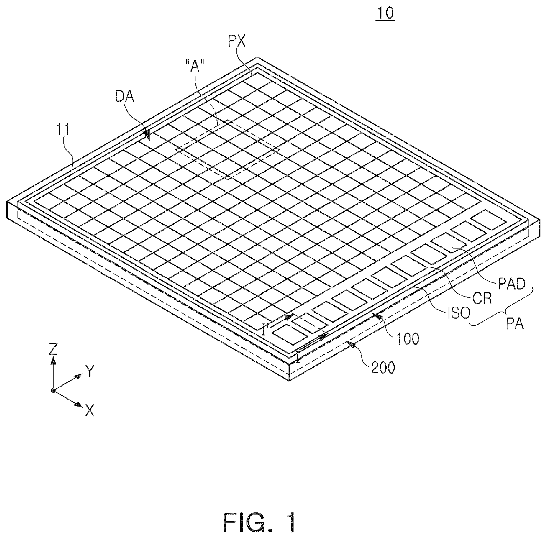

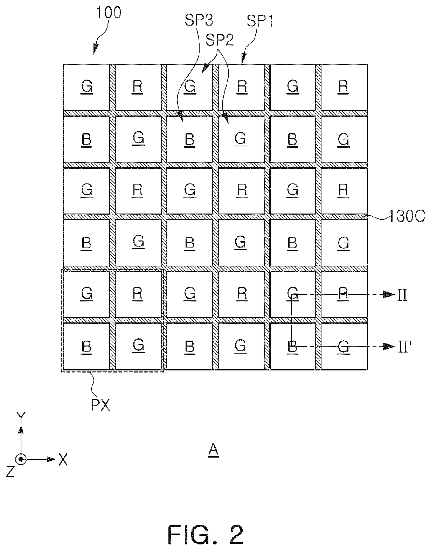

FIG. 1 is a schematic perspective view of a display apparatus according to one or more example embodiments of the present disclosure. FIG. 2 is a partially enlarged plan view of portion "A" of the display apparatus in FIG. 1.

Referring to FIGS. 1 and 2, a display apparatus 10 according to the present example embodiment may include a circuit board 200 including driving circuits, and a pixel array 100 disposed on the circuit board 200, the pixel array 100 in which a plurality of pixels PX are arranged. In addition, the display apparatus 10 may further include a frame 11 surrounding the circuit board 200 and the pixel array 100.

The circuit board 200 may include a driving circuit including thin film transistor (TFT) cells. In some example embodiments, the circuit board 200 may further include other circuits than driving circuits for a display apparatus. In some example embodiments, the circuit board 200 may include a flexible board, and the display apparatus 10 may be implemented as a display apparatus having a curved profile.

The pixel array 100 may include a display region DA and a peripheral region PA positioned on at least one side of the display region DA. The display region DA may include an LED module for display. The pixel array 100 may have a display region DA in which the plurality of pixels PX are arranged. The peripheral region PA may include pad regions PAD, a connection region CR connecting the plurality of pixels PX and the pad regions PAD to each other, and an edge region ISO.

Each of the plurality of pixels PX may include first to third subpixels SP1, SP2, and SP3 configured to emit light having different colors so as to provide a color image. For example, the first to third subpixels SP1, SP2, and SP3 may be configured to emit red (R) light, green (G) light, and blue (B) light, respectively.

In some example embodiments, in each pixel PX (also referred to as a "pixel unit"), the first to third subpixels SP1, SP2, and SP3 may be arranged in a Bayer pattern. As illustrated in FIG. 2, each pixel PX may include first and third subpixels SP1 and SP3 (for example, red (R) and blue (B)) arranged in a first diagonal direction, and two second subpixels SP2 (for example, green (G)) arranged in a second diagonal direction, intersecting the first diagonal direction. A contact portion 130C of an electrode may be formed along the pixels PX to establish an electrical connection between the pixels and a semiconductor base layer.

In the present example embodiment, it is illustrated that each pixel PX includes the first to third subpixels SP1, SP2, and SP3 arranged in a 2×2 Bayer pattern. The present disclosure is not limited thereto. In other example embodiments, each pixel PX may be configured in another arrangement such as 3×3 or 4×4. In addition, in some example embodiments, each pixel PX may include a subpixel configured to emit light, for example, yellow light, having a color different from the exemplified colors (R), (G), and (B). In the pixel array 100 in FIG. 1, it illustrated that the plurality of pixels PX are arranged in 15×15. However, rows and columns may be implemented in any suitable number, for example, 1,024×768 or 1,800×1,350. For example, depending on a desired resolution, the plurality of pixels PX may have different arrangements.

The frame 11 may be a guide structure surrounding the pixel array 100. The frame 11 may include, for example, at least one of materials such as a polymer, ceramic, a semiconductor, or a metal. For example, the frame 11 may include a black matrix, which refers to a light-absorbing structure positioned between pixels to enhance contrast by blocking ambient light and preventing optical crosstalk. However, the frame 11 is not limited to a black matrix, and may include a white matrix or a structure having another color depending on a purpose of the display apparatus 10. For example, the white matrix may include a reflective material or a scattering material to improve overall brightness and light efficiency. Although FIG. 1 illustrates the display apparatus 10 as having a rectangular planar structure, the display apparatus 10 may have a different shape depending on example embodiments.

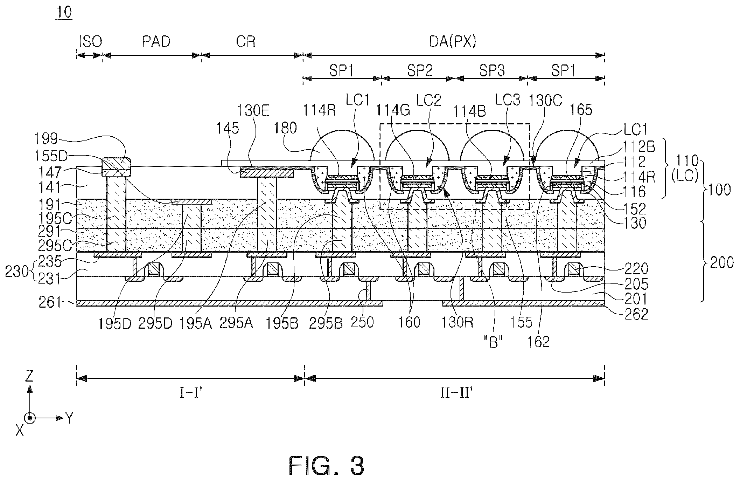

FIG. 3 is a schematic cross-sectional view of a display apparatus according to one or more example embodiments of the present disclosure. FIG. 3 illustrates a partial section (I-I') of the peripheral region PA of the display apparatus of FIG. 1 and a partial section (II-II') of the display region DA of the display apparatus of FIG. 2.

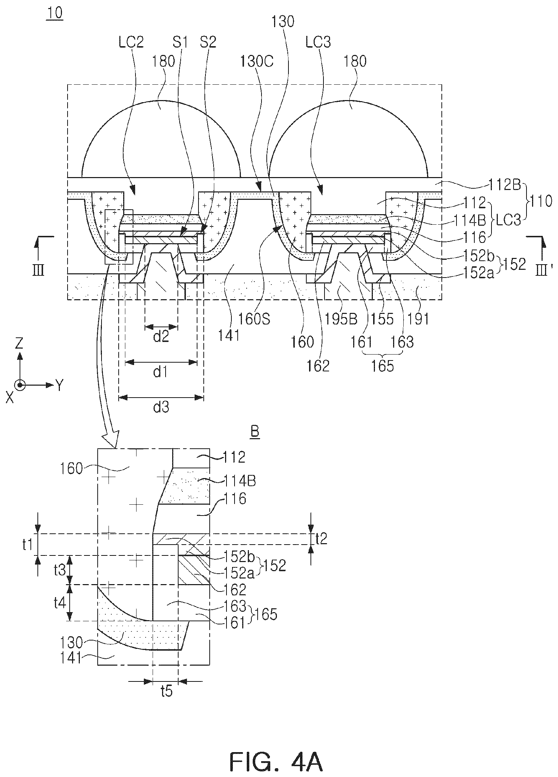

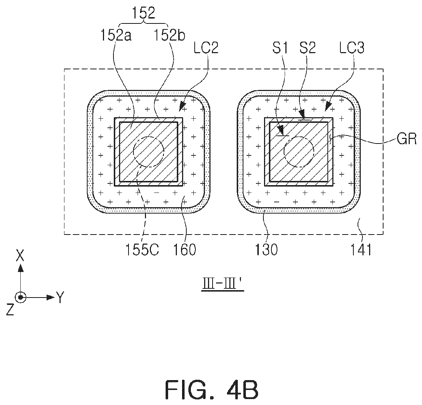

FIG. 4A is a partially enlarged cross-sectional view of portion "B" of the display apparatus in FIG. 3, and FIG. 4B is a schematic bottom view of a contact electrode according to one or more example embodiments.

Referring to FIGS. 3, 4A, and 4B, a display apparatus 10 may include a pixel array 100 and a circuit board 200. The pixel array 100 may include a semiconductor stack 110 including first to third LED cells LC1, LC2, and LC3 configured to emit light having different wavelengths. The semiconductor stack 110 may have a first surface (or a lower surface) opposing the circuit board 200, and a second surface (or an upper surface) opposing the first surface. In the present example embodiment, the semiconductor stack 110 may include a first conductivity-type semiconductor base layer 112B providing the second surface of the semiconductor stack 110, and a plurality of LED cells LC1, LC2, and LC3 disposed on a lower surface of the first conductivity-type semiconductor base layer 112B. An upper surface of the first conductivity-type semiconductor base layer 112B may be provided as the second surface of the semiconductor stack 110, that is, a light emitting surface.

Each of the plurality of LED cells LC1, LC2, and LC3 may include at least active layers 114R, 114G, and 114B stacked on the lower surface of the first conductivity-type semiconductor base layer 112B, and a second conductivity-type semiconductor layer 116. The active layers 114R, 114G, and 114B may refer to regions within the LED cells where light is generated through electroluminescence, with a quantum well structure in which electrons and holes recombine when a voltage is applied, resulting in the emission of light. The first conductivity-type semiconductor base layer 112B may be a base layer shared by the first to third LED cells LC1, LC2, and LC3, and may provide a contact region for driving the plurality of LED cells LC1, LC2, and LC3. In the present example embodiment, the first conductivity-type semiconductor base layer 112B may be formed to have a thickness for reducing a light leakage effect while providing a contact region. In some example embodiments, the thickness of the first conductivity-type semiconductor base layer 112B may be within a range from 0.1 µm to 2 µm.

The plurality of LED cells LC1, LC2, and LC3 may respectively have a micro LED structure, and may be arranged to respectively correspond to the first to third subpixels SP1, SP2, and SP3. The LED cells LC may be arranged in a plurality of rows and a plurality of columns, in plan view (see FIG. 2). The plurality of LED cells LC1, LC2, and LC3 may be provided as light sources of the subpixels SP1, SP2, and SP3. In the present example embodiment, the plurality of LED cells LC1, LC2, and LC3 may include active layers 114R 114G, and 114B emitting light having different wavelengths. Each of first LED cells LC1 may include a first active layer 114R configured to emit red light, for example, light having a wavelength of 620 nm to 660 nm, and may be provided as a red subpixel SP1. Each of second LED cells LC2 may include a second active layer 114G configured to emit green light, for example, light having a wavelength of 510 nm to 550 nm, and may be provided as a green subpixel SP2. Each of third LED cells LC3 may include a third active layer 114B configured to emit blue light, for example, light having a wavelength of 430 nm to 480 nm, and may be provided as a blue subpixel SP3. The first to third active layers 114R, 114G, and 114B may have different emission efficiencies depending on emission wavelengths. For smooth color reproduction of the display apparatus 10, an area of an LED cell may be changed or a configuration (number of quantum wells) of an active layer may be changed so as to reduce a variation between amounts of light emitted from different subpixels SP1, SP2, and SP3.

Each of the plurality of LED cells LC1, LC2, and LC3 according to the present example embodiment may further include a first conductivity-type semiconductor layer 112 between the first conductivity-type semiconductor base layer 112B and the active layers 114R, 114G, and 114B. The first conductivity-type semiconductor layer 112 may be a portion obtained by etching the first conductivity-type semiconductor base layer 112B. The active layers 114R, 114G, and 114B of the first to third LED cells LC1, LC2, and LC3 may be configured to emit light having different wavelengths (for example, red, green, and blue). In the present example embodiment, the first to third active layers 114R, 114G, and 114B of the first to third LED cells may include quantum well layers having different indium contents.

The first conductivity-type semiconductor base layer 112B and the first conductivity-type semiconductor layer 112 may respectively be a nitride epitaxial layer having a composition of N-type InₓAl_{y}Ga_{1-x-y}N(0≤x<1, 0≤y<1, 0≤x+y<1). For example, the first conductivity-type semiconductor layer 112 may be an N-type gallium nitride (n-GaN) layer doped with silicon (Si), germanium (Ge), or carbon (C). In particular, the first conductivity-type semiconductor base layer 112B may include a high-concentration N-type nitride (n⁺-GaN) layer provided as a contact region. The second conductivity-type semiconductor layer 116 may be a nitride semiconductor layer having a composition of P-type InₓAl_{y}Ga_{1-x-y}N(0≤x<1, 0≤y<1, 0≤x+y<1). For example, the second conductivity-type semiconductor layer 116 may be a P-type nitride (p-GaN) layer doped with magnesium (Mg) or zinc (Zn). The first conductivity-type semiconductor layer 112 and the second conductivity-type semiconductor layer 116 may be respectively formed as a single layer, but may also include a plurality of layers having different properties such as a doping concentration, a composition, or the like.

The semiconductor stack 110 of the first to third LED cells LC1, LC2, and LC3 according to the present example embodiment may include a nitride epitaxial layer grown on the same substrate. A growth substrate may include a substrate for nitride single crystal growth, for example, at least one of sapphire, silicon (Si), silicon carbide (SiC), magnesium aluminate (MgAl₂O₄), magnesium oxide (MgO), lithium aluminate (LiAlO₂), lithium gallate (LiGaO₂), and gallium nitride (GaN). In some example embodiments, in order to improve crystallinity and light extraction efficiency of the nitride epitaxial layers, the growth substrate may have an uneven structure on at least a portion of an upper surface thereof.

The plurality of LED cells LC1, LC2, and LC3 may include a contact electrode 152 disposed on the second conductivity-typesemiconductor layers 116. The contact electrode 152 may be a transparent electrode formed of one of a transparent conductive oxide and a nitride. For example, the contact electrode 152 may be at least one selected from indium tin oxide (ITO), zinc-doped indium tin oxide (ZIO), zinc indium oxide (GIO), zinc oxide (ZnO), zinc oxide (ZTO), fluorine-doped tin oxide (GTO), aluminum-doped zinc oxide (AZO), gallium-doped zinc oxide (GZO), gallium-doped zinc oxide (GZO), In₄Sn₃O₁₂, and zinc magnesium oxide (Zn₍₁₋ₓ₎MgₓO, where 0≤x≤1).

According to one or more example embodiments, the display apparatus 10 may further include a cover electrode 162 and a capping layer 165. The cover electrode 162 may be disposed on a lower surface of the contact electrode 152. The cover electrode 162 may be in contact with an upper end portion ("first lower surface S1") of the lower surface of the contact electrode 152. The cover electrode 162 may include a metal material for ohmic contact with the contact electrode 152. The cover electrode 162 may include, for example, silver (Ag), nickel (Ni), aluminum (Al), chromium (Cr), rhodium (Rh), iridium (Pd), palladium (Pd), ruthenium (Ru), magnesium (Mg), zinc (Zn), platinum (Pt), gold (Au), copper (Cu), titanium (Ti), tantalum (Ta), and tungsten (W). The cover electrode 162 may reflect light transmitted through the contact electrode 152 toward light emitting surfaces of a reflective electrode 130 and the first conductivity-type semiconductor base layer 112B, thereby improving light extraction efficiency (LEE) of the display apparatus 10.

In one or more example embodiments, the cover electrode 162 may be in contact with the first surface S1 of the contact electrode 152. The contact electrode 152 may include a central portion 152a providing a first lower surface S1, and a peripheral portion 152b providing a second lower surface S2. The central portion 152a may overlap the cover electrode 162 in a vertical direction Z. The peripheral portion 152b may surround the central portion 152a, and may define a groove region GR. The groove region GR may extend along a circumference of the central portion 152a. A thickness t1 of the central portion 152a in the vertical direction Z may be greater than a thickness t2 of the central portion 152a in the vertical direction Z. The first lower surface S1 and the second lower surface S2 may have a step portion in the vertical direction. An area of the first lower surface S1 of the contact electrode 152 may be greater than an area of each of the second lower surface S2 of the contact electrode 152 and a contact region 155C of a connection electrode 155.

A width d1 of the contact electrode 152 may be greater than an upper width d2 of each of the connection electrodes 155 in contact with the contact electrode 152, and may be less than a width d3 of the contact electrode 152. The width d1 of the cover electrode 162 may be substantially equal to a width of the central portion 152a of the contact electrode 152. A difference between the width d1 of the cover electrode 162 and the width d3 of the contact electrode 152 may be about 200 nm or less. That is, a width of the peripheral portion 152b of the contact electrode 152 may be about 100 nm or less. The cover electrode 162 may be formed to have a thickness t3 capable of securing light reflection efficiency. The thickness t3 of the cover electrode 162 in the vertical direction Z may be greater than the thickness t1 of the central portion 152a. The thickness t3 of the cover electrode 162 may be about 100 nm or more, but the present disclosure is not limited thereto.

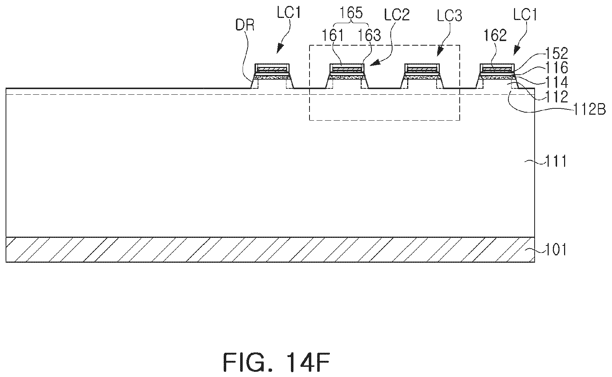

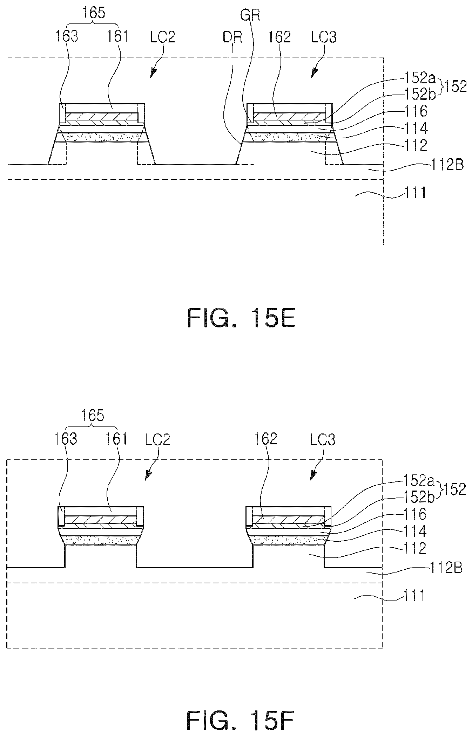

As illustrated in FIG. 4B, a planar shape of the cover electrode 162 may be substantially the same as a planar shape of the contact electrode 152 defined by the first lower surface S1 and the second lower surface S2. Such a configuration may be implemented by a process of forming the contact electrode 152 using the cover electrode 162 and the capping layer 165 as masks (see FIGS. 14F and 15E). Accordingly, the cover electrode 162 may overlap a substantial portion of the lower surface of the contact electrode 152. An area of the cover electrode 162 may be within a range from about 60% or more, for example, from about 60% to about 90% of an area of the contact electrode 152.

The capping layer 165 may cover at least a portion of each of the cover electrode 162 and the contact electrode 152. The capping layer 165 may surround a side surface of the cover electrode 162, and may protect the cover electrode 162 in a process of forming the LED cells LC1, LC2, and LC3. The capping layer 165 may include at least one of SiO, SiN, SiON, TiO, HfO, AlN, AlO, and ZrO. The capping layer 165 may include a first capping layer 161 overlapping the cover electrode 162 in the vertical direction Z, and a second capping layer 163 surrounding the side surface of the cover electrode 162. The first capping layer 161 may have a contact hole connected to a lower surface of the cover electrode 162. The second capping layer 163 may extend along a side surface of the first capping layer 161 and a side surface of the cover electrode 162. The second capping layer 163 may fill the groove region GR formed around the contact electrode 152. A thickness t4 of the first capping layer 161 in the vertical direction may be greater than a thickness t5 of the second capping layer 163 in a horizontal direction Y. The thickness t5 of the second capping layer 163 may be about 100 nm or less, for example, within a range of 100 nm to 10 nm.

The first to third LED cells LC1, LC2, and LC3 according to the present example embodiment may have side surfaces inclined with respect to a lower surface of the first conductivity-type semiconductor base layer 112B. For example, the side surfaces of the first to third LED cells LC1, LC2, and LC3 may have an inclination angle of 85° to 95°. The side surfaces of the first to third LED cells LC1, LC2, and LC3 may be obtained by an etching process (see FIG. 15E and 15F) of removing a damage layer on a side surface of an LED cell. A defective region, causing a leakage current, may be removed through the etching process. Due to a material difference (for example, a difference in indium content) between layers included in the first to third LED cells LC1, LC2, and LC3 (see FIGS. 15E and 15F), an inclination angle difference between the side surfaces of the first to third LED cells LC1, LC2, and LC3 may occur during the etching process described above. The first conductivity-type semiconductor layer 112, the active layers 114R, 114G and 114B, and the second conductivity-type semiconductor layer 116 may have side surfaces having different inclinations. For example, the second conductivity-type semiconductor layer 116 and the active layers 114R, 114G and 114B may be tapered upwardly. An average width of the second conductivity-type semiconductor layer 116 may be greater than an average width of each of the active layers 114R, 114G and 114B. For example, a minimum width of the second conductivity-type semiconductor layer 116 may be greater than or equal to a maximum width of each of the corresponding active layers 114R, 114G and 114B.

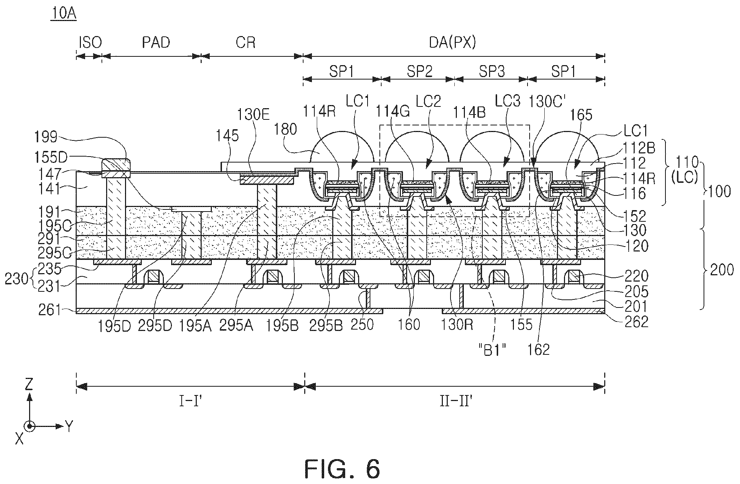

In some example embodiments, the lower surface (or an upper surface of the growth substrate) of the first conductivity-type semiconductor base layer 112B may be a (0001) crystal plane, and the side surfaces of the LED cells LC1, LC2, and LC3 may be m surfaces. In some example embodiments, a passivation layer may be formed to cover the side surfaces and lower surfaces of the first to third LED cells LC1, LC2, and LC3 (see FIGS. 6 to 9, 12, and 13).

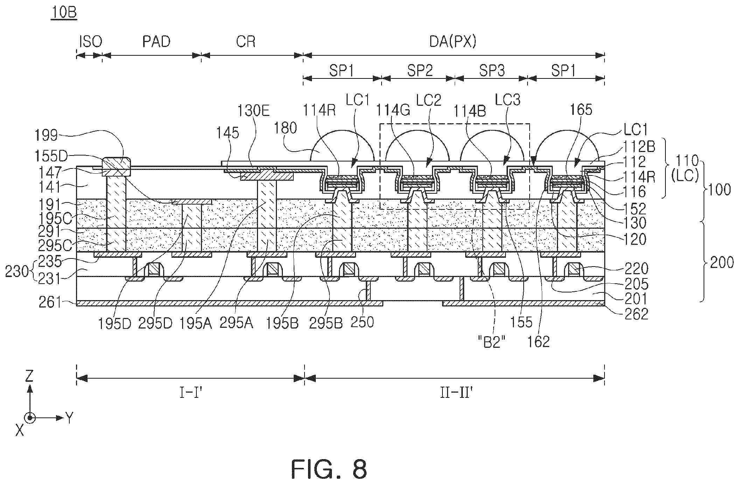

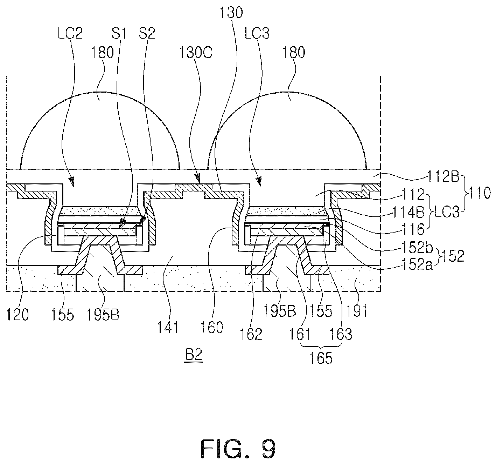

The pixel array 100 may include a reflective structure configured to emit light to upper surfaces of the first to third LED cells LC1, LC2, and LC3. The reflective structure according to the present example embodiment may include a spacer 160 having an inclined outer sidewall 160S, and a reflective electrode 130 connected to the first conductivity-type semiconductor base layer 112B. The inclined outer sidewall 160S may have a curved boundary surface. In some example embodiments, the spacer 160 may be omitted, and the reflective electrode 130 may be formed along the side surfaces of the LED cells LC1, LC2, and LC3 (see FIGS. 8 and 9).

The spacer 160 may be formed on the side surfaces of the plurality of LED cells LC1, LC2, and LC3 to provide the inclined outer sidewall 160S. The inclined outer sidewall 160S may have a curved, slide-like profile, forming a non-linear and inclined surface between its side and bottom surfaces. The curve of the inclined outer sidewall 160S may be concave, bowing inward. According to one or more example embodiments, the spacer 160 may extend up to the lower surfaces of the plurality of LED cells LC1, LC2, and LC3. For example, the spacer 160 may cover a lower surface of the capping layer 165, and the connection electrode 155 may pass through the spacer 160.

The reflective electrode 130 may extend along the outer sidewall 160S of the spacer 160. The reflective electrode 130 may form the reflective portion 130R having a structure similar to a bowl shape. The reflective electrode 130 may effectively capture light generated from the LED cells LC1, LC2, and LC3 into a desired region. The reflective electrode 130 may extend to one region of the first conductivity-type semiconductor base layer 112B between the plurality of LED cells LC1, LC2, and LC3 to serve as a first electrode driving the LED cells LC1, LC2, and LC3. The first electrode may be a P-type electrode or a P-type transparent electrode. However, embodiments of the present disclosure are not limited to these configuration. The first electrode may be implemented as an N-type electrode or an opaque electrode. The reflective electrode 130 may have a contact portion 130C connected to the one region of the first conductivity-type semiconductor base layer 112B.

The contact portion 130C of the reflective electrode 130, provided as the first electrode, may be connected along a region between the plurality of LED cells LC1, LC2, and LC3. As illustrated in FIG. 2, in plan view, the reflective electrodes 130 (in particular, the contact portion 130C may have a grid or mesh structure in which the contact portion 130C extend in a X-direction and a Y-direction and are connected. A side cross-section of the reflective electrode 130 may have an inverted U-shape between adjacent LED cells LC1, LC2, and LC3. The reflective electrode 130 may include a reflective electrode material, and for example, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), copper (Ti), titanium (Ti), tantalum (Ta), and tungsten (W). In some example embodiments, the reflective electrode 130 may include a single layer structure or multilayer structure.

The reflective electrode 130 may have an extension portion 130E extending from the display region DA to the peripheral region PA. In the connection region CR, a common electrode 145 may be disposed on the extension portion 130E of the reflective electrode 130. A pad electrode 147 may be positioned in the pad region PAD, may be positioned on a gap-fill insulating layer 141 in a similar manner to the common electrode 145, and may be connected to a bonding pad 199 for connection with an external circuit on the pad electrode 147.

The pixel array 100 may further include a gap-fill insulating layer 141 disposed on a lower surface of the semiconductor stack 110, the gap-fill insulating layer 141 covering the reflective electrode 130. The gap-fill insulating layer 141 may have a contact hole passing through the capping layer 165, the contact hole connected to one region of the cover electrode 162. The connection electrodes 155 may be electrically connected to the contact electrodes 152 of the plurality of LED cells LC1, LC2, and LC3 through the contact hole, respectively. The connection electrodes 155 may be provided as individual electrodes for independently driving the plurality of LED cells LC1, LC2, and LC3.

The pixel array 100 may include an upper bonding insulating layer 191 disposed on a lower surface of the gap-fill insulating layer 141, and upper bonding electrodes 195A, 195B, 195C, and 195D electrically connected to the reflective electrode 130 and the connection electrodes 155, respectively. The upper bonding electrodes 195A, 195B, 195C, and 195D may be electrically connected to the reflective electrode 130 and the connection electrodes 155. The upper bonding electrodes 195A, 195B, 195C, and 195D may have a post-like shape (e.g., elongated cylindrical form). Upper surfaces of the upper bonding electrodes 195A, 195B, 195C, and 195D may be flat surfaces, substantially coplanar with an upper surface of the upper bonding insulating layer 191. The coplanar surface may be a lower surface of the pixel array 100, and may be provided as a bonding surface for bonding to the circuit board 200. The upper bonding electrodes 195A, 195B, 195C, and 195D may include a conductive material, for example, copper (Cu). For example, the upper bonding insulating layer 191 may include at least one of SiO, SiN, SiCN, SiOC, SiON, and SiOCN.

As described above, the common electrode 145 and the pad electrode 147 may be disposed in the connection region CR and the pad regions PAD, respectively. The common electrode 145 may be provided as a common electrode structure for driving the LED cells LC1, LC2, and LC3, together with the reflective electrode 130. The pad electrode 147 may be disposed in the pad regions PAD, and may be connected to the bonding pad 199 for connection with an external circuit, on the pad electrode 147.

The common electrode 145 and the pad electrode 147 may include a conductive material, for example, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), and gold (Au). For example, the bonding pad 199 may include at least one of gold (Au), silver (Ag), and nickel (Ni).

In the present example embodiment, depending on a connection target, the upper bonding electrodes 195A, 195B, 195C, and 195D may include a first upper bonding electrode 195A electrically connected to the reflective electrode 130, second upper bonding electrodes 195B electrically connected to the connection electrodes 155, respectively, and a third upper bonding electrode 195C connected to the pad electrode 147. As illustrated in FIG. 3, the first upper bonding electrode 195A may pass through the upper bonding insulating layer 191 and the gap-fill insulating layer 141 and land on the common electrode 145, and may be, in common, connected to one side (in particular, the first conductivity-type semiconductor base layer 112B) of each of the LED cells LC1, LC2, and LC3 through the common electrode 145 and the reflective electrode 130. The second upper bonding electrodes 195B may pass through the upper bonding insulating layer 191 and respectively land on the connection electrode 155, and may be individually connected to the other side (in particular, the second conductivity-type semiconductor layer 116) of each of the LED cells LC1, LC2, and LC3 through the first connection electrode 155, the cover electrode 162, and the contact electrode 152. In addition, the third upper bonding electrode 195C may pass through the upper bonding insulating layer 191 and the gap-fill insulating layer 141 and land on the pad electrode 147, and may be connected to the bonding pad 199 for connection to an external circuit through the pad electrode 147.

The circuit board 200 according to the present example embodiment may include a device board 201 on which a driving circuit 220 is disposed, and lower bonding structures 291, 295A, 295B, 295C, and 295D disposed on the device board 201. The circuit board 200 may include an interlayer connection structure 230 between the device board 201 and the lower bonding structures 291, 295A, 295B, 295C, and 295D. The interlayer connection structure 230 may include an interconnection insulating layer 231 on the device board 201, and an interconnection circuit 235 electrically connected to the driving circuit 220 in the interconnection insulating layer 231. The driving circuit 220 may include thin film transistor (TFT) cells.

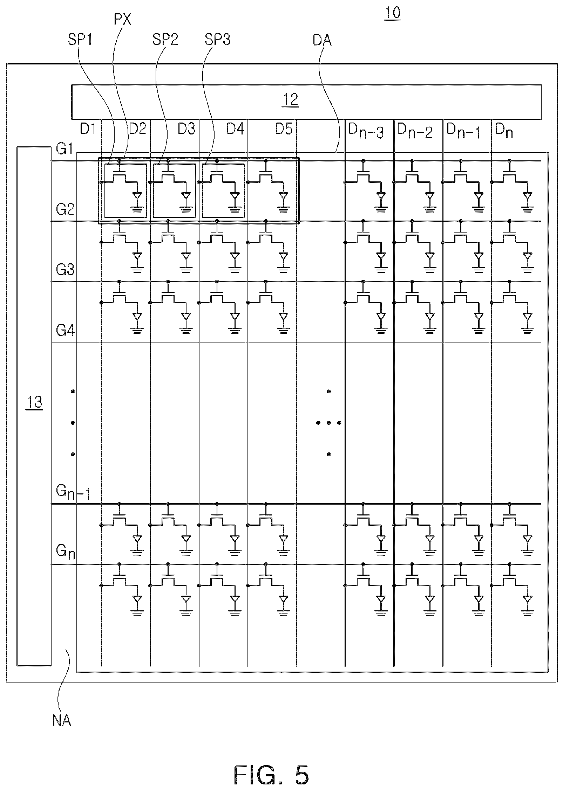

The device board 201 may be a semiconductor board having impurity regions having source/drain regions 205. The device board 201 may include, for example, a semiconductor such as silicon (Si) or germanium (Ge), or a compound semiconductor such as SiGe, SiC, GaAs, InAs, or InP. The device board 201 may further include through-electrodes 250 such as a through-silicon via (TSV) connected to the driving circuit, and first and second substrate wiring lines 261 and 262 connected to the through-electrodes 250.The driving circuit 220 may control the driving of a pixel, in particular, a subpixel. A source region 205 of the TFT cells may be electrically connected to one side of each of the LED cells LC1, LC2, and LC3 through the interlayer connection structure 230 and the lower bonding structures 291, 295A, 295B, 295C, and 295D. For example, a drain region 205 of the TFT cells may be connected to a data line through the interconnection circuit 235. Gate electrodes of the TFT cells may be connected to a gate line through the interconnection circuit 235. A configuration and an operation of the circuit will be described in more detail with reference to FIG. 5 below.

The lower bonding structures 291, 295A, 295B, 295C, and 295D may include a lower bonding insulating layer 291 and lower bonding electrodes 295A, 295B, 295C, and 295D disposed on the lower bonding insulating layer 291, the lower bonding electrodes 295A, 295B, 295C, and 295D electrically connected to the driving circuit 220. The lower bonding electrodes 295A, 295B, 295C, and 295D may be electrically connected to the driving circuit 220 through an interconnection circuit 235. For example, the lower bonding electrodes 295A, 295B, 295C, and 295D may be provided as pillar structures. Upper surfaces of the lower bonding electrodes 295A, 295B, 295C, and 295D may be flat surfaces, substantially coplanar with an upper surface of the lower bonding insulating layer 291. The coplanar surface may be provided as a bonding surface for bonding to the pixel array 100 as an upper surface of the circuit board 200. The lower bonding electrodes 295A, 295B, 295C, and 295D may include a conductive material, for example, copper (Cu). For example, the lower bonding insulating layer 291 may include at least one of SiO, SiN, SiCN, SiOC, SiON, and SiOCN.

The lower bonding electrodes 295A, 295B, 295C, and 295D of the circuit board 200 and the upper bonding electrodes 195A, 195B, 195C, and 195D of the pixel array 100 may be bonded to each other to provide an electrical connection path between the circuit board 200 and the pixel array 100. In addition, the upper bonding insulating layer 191 of the pixel array 100 may be bonded to the lower bonding insulating layer 291 of the circuit board 200.

As described, the circuit board 200 and the pixel array 100 may be coupled to each other by bonding between the lower bonding electrodes 295A, 295B, 295C, and 295D and the upper bonding electrodes 195A, 195B, 195C, and 195D and bonding between the lower bonding insulating layer 291 and the upper bonding insulating layer 191. Bonding between the lower bonding electrodes 295A, 295B, 295C, and 295D and the upper bonding electrodes 195A, 195B, 195C, and 195D may be, for example, copper (Cu)-copper (Cu) bonding, and bonding between the lower bonding insulating layer 291 and the upper bonding insulating layer 191 may be dielectric-dielectric bonding, for example, dielectric-dielectric bonding such as SiCN-SiCN bonding. The circuit board 200 and the pixel array 100 may be bonded to each other by hybrid bonding including copper (Cu)-copper (Cu) bonding and dielectric-dielectric bonding, and may be bonded to each other without an adhesive layer.

Depending on a connection target, the lower bonding electrodes 295A, 295B, 295C, and 295D may be divided into first to third lower bonding electrodes 295A, 295B, and 295C, respectively, in a similar manner to the upper bonding electrodes 195A, 195B, 195C, and 195D. Specifically, the first lower bonding electrode 295A may be bonded to the first upper bonding electrode 195A, such that each of the reflective electrode 130 may be electrically connected to the driving circuit 220 through the common electrode 145. The second lower bonding electrodes 295B may be respectively bonded to the second upper bonding electrodes 195B to electrically connect the connection electrode 155, an individual electrode, to the driving circuit 220.

As described, the plurality of LED cells LC1, LC2, and LC3 may be connected to the driving circuit 220 by bonding between the first upper and lower bonding electrodes 195A and 295A and bonding between the second upper and lower bonding electrodes 195B and 295B, such that the plurality of LED cells LC1, LC2, and LC3 may be individually driven. In addition, the third lower bonding electrode 295C may be bonded to the third upper bonding electrode 195C to be electrically connect the bonding pad 199 to the driving circuit 220 through the pad electrode 145.

In the present example embodiment, the lower bonding electrodes 295A, 295B, 295C, and 295D may further include a lower dummy bonding electrode 295D, not connected to the driving circuit 220. Similarly, the upper bonding electrodes 195A, 195B, 195C, and 195D may further include an upper dummy bonding electrode 195D connected to the lower dummy bonding electrode 295D, the upper dummy bonding electrode 195D not connected to the plurality of LED cells LC1, LC2, and LC3. The upper and lower dummy bonding electrodes 195D and 295D may be arranged at regular intervals from the other bonding electrodes 195A, 195B, 195C, 295A, 295B, and 295C over the entire area. In some example embodiments, the upper dummy bonding electrode 195D may be formed on a dummy pad 155D not connected to the plurality of LED cells LC1, LC2, and LC3, and the dummy pad 155D may be formed together with the connection electrodes 155.

Microlenses 180 may be respectively disposed on the LED cells LC1, LC2, and LC3 to converge light emitted from the LED cells LC1, LC2, and LC3. The microlenses 180 may be configured to adjust an orientation angle of light emitted from the LED cells LC1, LC2, and LC3. In the present example embodiment, the microlenses 180 may be disposed on the first conductivity-type semiconductor base layer 112B. For example, the microlenses 180 may have a diameter greater than the widths of the LED cells LC1, LC2, and LC3 in the X-direction and the Y-direction.

The microlenses 180 may be formed of, for example, a transparent photoresist material or a transparent thermosetting resin film. The microlenses 180 according to the present example embodiment may have the same shape and size. However, in some example embodiments, the microlenses 180 may have different shapes and/or sizes depending on the areas of the first to third LED cells LC1, LC2, and LC3.

FIG. 5 is a driving circuit implemented in a display apparatus according to one or more example embodiments of the present disclosure.

Referring to FIG. 5, a circuit diagram of a display apparatus 10 in which n×n subpixels are arranged is illustrated. The first to third subpixels SP1, SP2, and SP3 may respectively receive a data signal through data lines D1 to Dn, paths in a vertical direction, for example, a column direction. The first to third subpixels SP1, SP2, and SP3 may receive a control signal, that is, a gate signal, through gate lines G1 to Gn, paths in a horizontal direction, for example, a row direction.

A plurality of pixels PX including the first to third subpixels SP1, SP2, and SP3 may provide a display region DA, and the display region DA, an active region, may be provided as a display region for a user. An inactive region NA (or a peripheral region PA) may be formed along one or more edges of the display region DA. The inactive region NA may extend along an outer periphery of a panel of the display apparatus 10.

A first driver circuit 12 and a second driver circuit 13 may be used to control operation of the pixels PX, that is, the first to third subpixels SP1, SP2, and SP3. A portion or all of the first and second driver circuits 12 and 13 may be implemented in the circuit board 200. The first and second driver circuits 12 and 13 may be configured as integrated circuits, thin film transistor panel circuits, or other suitable circuits, and may be disposed in the inactive region NA of the display apparatus 10. The first and second driver circuits 12 and 13 may include a microprocessor, a memory such as storage, a processing circuit, and a communication circuit.

In order to display an image by the pixels PX, the first driver circuit 12 may supply image data to the data lines D1 to Dn, and may transmit a clock signal and other control signals to the second driver circuit 13, a gate driver circuit. The second driver circuit 13 may be implemented using an integrated circuit and/or a thin film transistor circuit. A gate signal for controlling the first to third subpixels SP1, SP2, and SP3 arranged in the row direction may be transmitted through the gate lines G1 to Gn of the display apparatus 10.

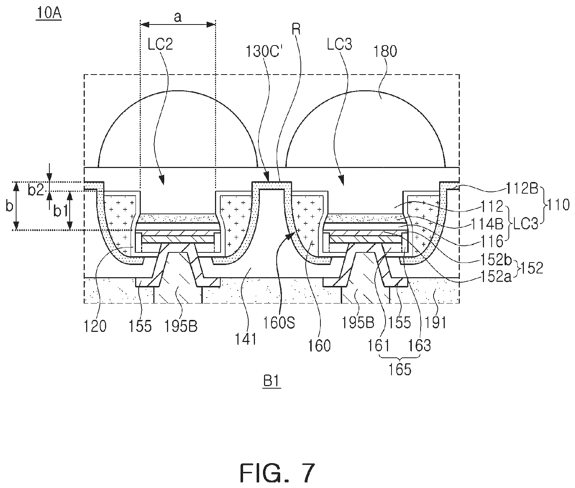

FIG. 6 is a schematic cross-sectional view of a display apparatus 10A according to one or more example embodiments of the present disclosure. FIG. 7 is a partially enlarged cross-sectional view of portion "B1" of the display apparatus 10A in FIG. 6.

Referring to FIGS. 6 and 7, a display apparatus 10A according to the present example embodiment may be understood as being similar to the display apparatus 10 illustrated in FIGS. 1 to 5, except that a passivation layer 120 is added to surfaces of a plurality of LED cells LC1, LC2, and LC3 and that a first conductivity-type semiconductor base layer 112B has a recess R. In addition, unless otherwise described, components of the present example embodiment may be understood with reference to descriptions of the same or similar components of the display apparatus 10 illustrated in FIGS. 1 to 5.

The display apparatus 10A according to the present example embodiment may further include a passivation layer 120 covering side and lower surfaces of each of a plurality of LED cells LC1, LC2, and LC3 below a spacer 160. The passivation layer 120 may be formed to cover side and lower surfaces of first to third LED cells LC1, LC2, and LC3. In the present example embodiment, the passivation layer 120 may be formed up to a portion of a first conductivity-type semiconductor base layer 112B between the first to third LED cells LC1, LC2, and LC3. In addition, the passivation layer 120 may extend up to a region of a first conductivity-type semiconductor base layer 112B positioned in a connection region CR. For example, the passivation layer 120 may be disposed in the connection region CR to cover a lower surface of the first conductivity-type semiconductor base layer 112B. The passivation layer 120 may include an insulating material, for example, at least one of SiO, SiN, SiCN, SiOCN, SiOCN, SiOCN, HfO, AlO, ZrO, and AlN. In some example embodiments, the passivation layer 120 may include two or more insulating layers.

As illustrated in FIG. 7, a region of the first conductivity-type semiconductor base layer 112B between the plurality of LED cells LC1, LC2, and LC3 may have a recess R. A reflective electrode 130 may have a contact portion 130C' connected to a bottom of the recess R. A first conductivity-type semiconductor layer (for example, n⁺-GaN), doped at a high concentration, may be exposed to the bottom of the recess R. In the present example embodiment, the recess R may be defined as a region between adjacent spacers 160. The region of the first conductivity-type semiconductor base layer 112B between the plurality of LED cells LC1, LC2, and LC3 may include regions in which the spacer 160 is positioned, and a recess R between the regions. The reflective electrode 130 may be connected to the bottom of the recess R along an outer sidewall 160S of the spacer 160.

As described above, in the present example embodiment, even when the LED cells LC1, LC2, and LC3 are formed to have a relatively small height b 1, a contact portion 130C' may be exposed through additional etching during formation of a recess. A depth b from a lower surface of a second conductivity-type semiconductor layer 116 to the desired contact portion 130C' may be a sum of the height b1 of the plurality of LED cells LC1, LC2, and LC3 and a depth b2 of the recess R. As a result, the plurality of LED cells LC1, LC2, and LC3 may be formed to have a relatively small aspect ratio. For example, an aspect ratio b1/a of the plurality of LED cells LC1, LC2, and LC3 may be 1 or less. The recess R may be formed using the adjacent spacers 160 as masks.

FIG. 8 is a schematic cross-sectional view of a display apparatus 10B according to one or more example embodiments of the present disclosure. FIG. 9 is a partially enlarged cross-sectional view of portion "B2" of the display apparatus 10B in FIG. 8.

Referring to FIGS. 8 and 9, the display apparatus 10B according to the present example embodiment may be understood as being similar to the display apparatus 10 illustrated in FIGS. 1 to 5, except that a passivation layer 120 is added to surfaces of a plurality of LED cells LC1, LC2, and LC3 and that a spacer 160 is omitted. In addition, unless otherwise described, components of the present example embodiment may be understood with reference to descriptions of the same or similar components of the display apparatuses 10 and 10A illustrated in FIGS. 1 to 7.

In the present example embodiment, a passivation layer 120 may be formed to cover side and lower surfaces of first to third LED cells LC1, LC2, and LC3. A reflective electrode 130 may extend along a lower surface of the passivation layer 120. The reflective electrode 130 may pass through the passivation layer 120 in a region between a plurality of LED cells LC1, LC2, and LC3, and may be connected to a first conductivity-type semiconductor base layer 112B. In some example embodiments, the reflective electrode 130 may extend up to the lower surfaces of the first to third LED cells LC1, LC2, and LC3.

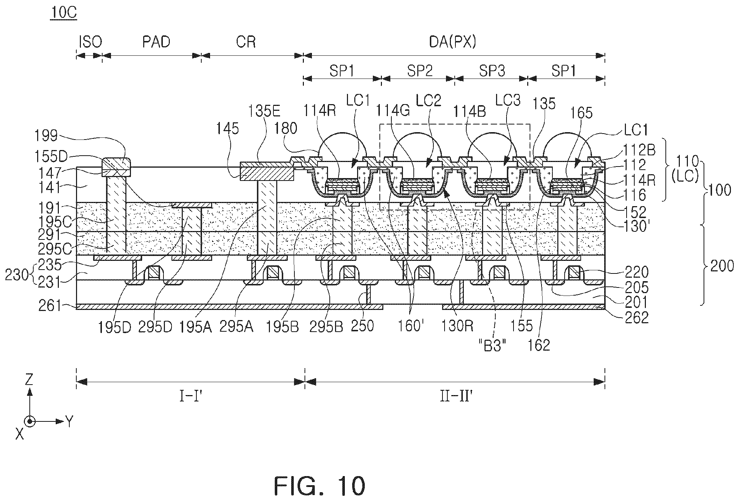

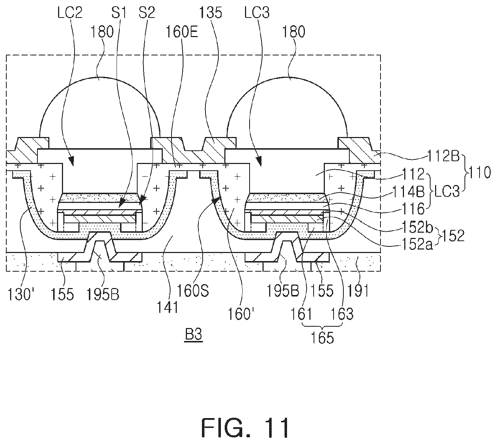

FIG. 10 is a schematic cross-sectional view of a display apparatus 10C according to one or more example embodiments of the present disclosure. FIG. 11 is a partially enlarged cross-sectional view of portion "B3" of the display apparatus 10C in FIG. 10.

Referring to FIGS. 10 and 11, the display apparatus 10C according to the present example embodiment may be understood as being similar to the display apparatus 10 illustrated in FIGS. 1 to 5, except that a spacer 160' has a portion 160E extending between a plurality of LED cells LC1, LC2, and LC3, a reflective electrode 130' is used as a portion of a second electrode structure, the plurality of LED cells LC1, LC2, and LC3 are separated from each other, and a first electrode 135 is connected to upper surfaces of the plurality of LED cells LC1, LC2, and LC3. In addition, unless otherwise described, components of the present example embodiment may be understood with reference to descriptions of the same or similar components of the display apparatuses 10, 10A, and 10B illustrated in FIGS. 1 to 9.

In the present example embodiment, each of the plurality of LED cells LC1, LC2, and LC3 may include a semiconductor stack 110 separated from each other, unlike the previous example embodiment. Each of the plurality of LED cells LC1, LC2, and LC3 may include a first conductivity-type semiconductor layer 112 having an upper surface provided as a light emitting surface, and active layers 114R, 114G, and 114B and a second conductivity-type semiconductor layer 116 sequentially stacked on a lower surface of the first conductivity-type semiconductor layer 112.

In a similar manner to the previous example embodiments, the spacer 160' may cover a side surface of each of the plurality of LED cells LC1, LC2 and LC3. However, in the present example embodiment, the spacer 160' may have an extending portion 160E between the plurality of LED cells LC1, LC2, and LC3. The extending portion 160E of the spacer 160' may prevent electrical connection between the reflective electrodes 130' and the first conductivity-type semiconductor layers 112.

In the present example embodiment, the reflective electrodes 130' may be disposed on the spacer 160' and used as a portion of a second electrode structure. The reflective electrodes 130' may be separated from each other and disposed on the LED cells LC1, LC2, and LC3, respectively. The reflective electrodes 130' may extend to a contact hole of a capping layer 165, and may be connected to a cover electrode 162. Connection electrodes 155 may be connected to the reflective electrodes 130' through a contact hole of a gap-fill insulating layer 141, respectively. As described, the reflective electrodes 130' may be used as individual electrodes for driving the LED cells LC1, LC2, and LC3, together with the connection electrodes 155.

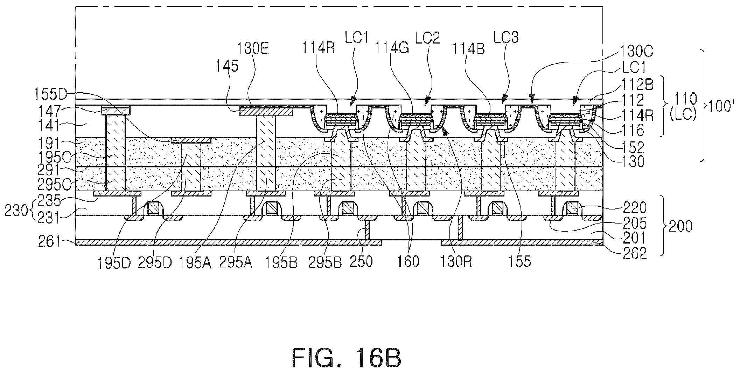

In the present example embodiment, the plurality of LED cells LC1, LC2, and LC3 may be separated from each other. A cell separation structure may be implemented by an additional etching process for separating a first conductivity-type semiconductor base layer 112B into a plurality of LED cells LC1, LC2, and LC3 after a process of removing a growth substrate or the like (see FIG. 16B).

In the present example embodiment, a first electrode 135 may be disposed on an upper surface of a pixel array 100. The first electrode 135 may be connected to a portion (in particular, an edge) of upper surfaces of the plurality of LED cells LC1, LC2, and LC3 along a region between the plurality of LED cells LC1, LC2, and LC3. The first electrode 135 may be used as a common electrode between the plurality of LED cells LC1, LC2, and LC3. The first electrode 135 may have an edge region 135E extending to a connection region CR. The edge region 135E of the first electrode 135 may be connected to a common electrode 145. In a similar manner to the previous example embodiment, the first electrode 135 may have a grid or mesh shape in plan view.

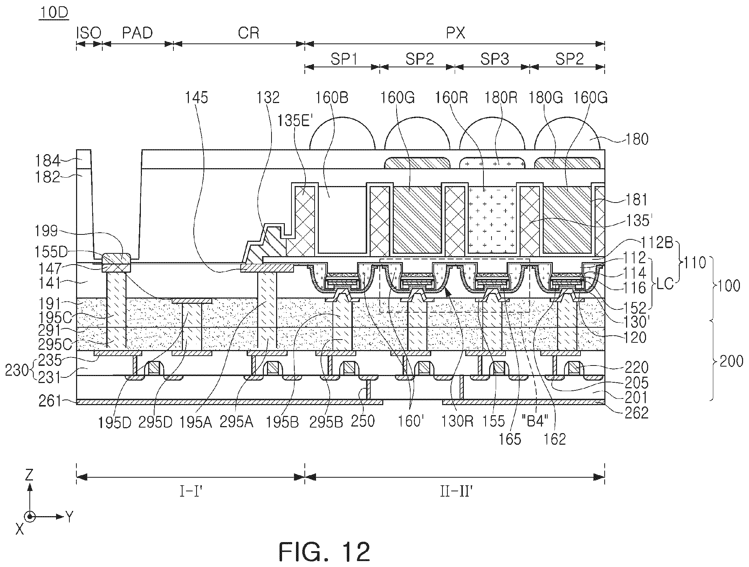

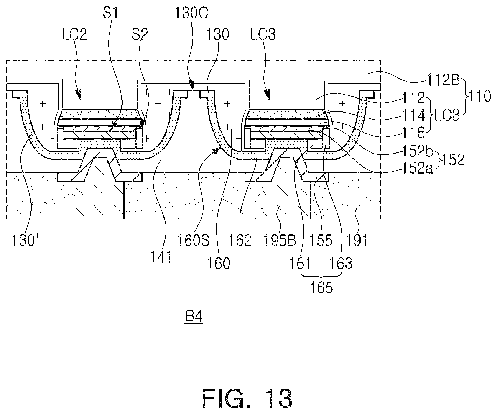

FIG. 12 is a schematic cross-sectional view of a display apparatus 10D according to one or more example embodiments of the present disclosure. FIG. 13 is a partially enlarged cross-sectional view of portion "B4" of the display apparatus 10D in FIG. 12.

Referring to FIGS. 12 and 13, the display apparatus 10D according to the present example embodiment may be understood as being similar to the display apparatus 10 illustrated in FIGS. 1 to 5, except that a spacer 160' has a portion 160E extending from each other between a plurality of LED cells LC, a reflective electrode 130' is used as a portion of a second electrode structure, a plurality of LED cells LC1, LC2, and LC3 are configured to emit light having the same wavelength, and a first electrode 135' is provided as a partition wall structure and has a wavelength conversion structure for first to third subpixels. In addition, unless otherwise described, components of the present example embodiment may be understood with reference to descriptions of the same or similar components of the display apparatuses 10, 10A, 10B, and 10C illustrated in FIGS. 1 to 11.

In the present example embodiment, a spacer 160' may have an extending portion 160E between a plurality of LED cells LC1, LC2, and LC3, in a similar manner to the example embodiments illustrated in FIGS. 10 and 11. The extending portion 160E of the spacer 160' may prevent electrical connection between reflective electrodes 130' and a first conductivity-type semiconductor base layer 112B. In addition, the reflective electrodes 130' may be disposed on the spacer 160' and used as a portion of a second electrode structure. Connection electrodes 155 may be connected to the reflective electrodes 130' through a contact hole of a gap-fill insulating layer 141, respectively. As described, the reflective electrodes 130' may be used as individual electrodes for driving the LED cells LC, together with the connection electrodes 155.

In the present example embodiment, the plurality of LED cells LC may include the same semiconductor stack to emit light having the same wavelength (for example, blue). For example, active layers 114 of the plurality of LED cells LC may have a multi-quantum well (MQW) structure configured to emit light having the same wavelength.

The plurality of LED cells LC may be connected to each other by the first conductivity-type semiconductor base layer 112B. An upper surface of the first conductivity-type semiconductor base layer 112B may be provided as a contact region. A conductive partition wall structure 135' may be disposed on an upper surface of the first conductivity-type semiconductor base layer 112B, and may be in direct contact with the first conductivity-type semiconductor base layer 112B. In such an arrangement, the conductive partition wall structure 135' may be provided as a first electrode for each LED cell LC. The conductive partition wall structure 135' may include a metal material for ohmic contact with the first conductivity-type semiconductor base layer 112B. The conductive partition wall structure 135', formed of a metal material, may be provided as a light blocking structure to prevent light interference from occurring between subpixels SP1, SP2, and SP3. For example, the conductive partition wall structure 135' may include Ag, Cr, Ni, Ti, Al, Rh, Ru, or combinations thereof. The conductive partition wall structure 135' may be provided as a single layer structure or multilayer structure.

The conductive partition wall structure 135' may have a grid shape or a mesh shape extending in an X-direction and a Y-direction along regions between the subpixels SP1, SP2, and SP3, on an upper surface of a semiconductor stack 110. The conductive partition wall structure 135' may be in contact with and electrically connected to the first conductivity-type semiconductor base layer 112B in a region between the LED cells LC.

The conductive partition wall structure 135' may have a peripheral region PA positioned on one side of a display region DA in which pixels PX are arranged, that is, an edge region 135E' extending to a connection region CR. As described above, the conductive partition wall structure 135' may be in direct contact with the first conductive semiconductor base layer 112B, and the edge region 135E' of the conductive partition wall structure 135' may be connected to a common electrode 145 through a mutual connection portion 132.

In the present example embodiment, a transparent insulating layer 181 may be formed on an upper surface and sidewalls of the conductive partition wall structure 135'. For example, the transparent insulating layer 181 may include at least one of SiO₂ and MgF₂. Each of wavelength conversion units 160R, 160G, and 160B for colors of the subpixels SP1, SP2, and SP3 may be formed in a subpixel space of the conductive partition wall structure 135' in which the transparent insulating layer 181 is formed. The wavelength conversion units 160R, 160G, and 160B may be disposed to correspond to the LED cells LC. The wavelength conversion units 160R, 160G, and 160B may include a wavelength conversion material, converting wavelengths of light emitted from the LED cells LC to generate final light having a desired color from respective subpixels SP1, SP2, and SP3. The wavelength conversion material may include a phosphor and/or a quantum dot, and the wavelength conversion units 160R, 160G, and 160B may be obtained by filling respective subpixel spacers with a liquid binder resin, in which the wavelength conversion material is dispersed, and then performing curing thereon.

When the active layers 114 of the plurality of LED cells LC are respectively configured to emit blue light, a first wavelength conversion unit 160R may be configured to convert the blue light into red light, and a second wavelength conversion unit 160G may be configured to convert blue light into green light. However, a third wavelength conversion unit 160B, applied to a subpixel space for a blue subpixel, may be replaced with a transparent material such as a transparent resin.

An encapsulation layer 182 may be disposed to cover upper surfaces of the wavelength conversion units 160R, 160G, and 160B. The encapsulation layer 182 may function as a protective layer preventing degradation in the wavelength conversion units 160R, 160G, and 160B. In some example embodiments, the encapsulation layer 182 may be omitted. Color filters 180R and 180G may be disposed on the wavelength conversion units 160R, 160G, and 160B in second and third subpixels SP2 and SP3. The color filters 180R and 180G may increase color purity of light emitted through the first wavelength conversion unit 160R and the second wavelength conversion unit 160G. In some example embodiments, a color filter may be further disposed on the third wavelength conversion unit 160B.

A planarization layer 184 may be disposed to cover upper surfaces of the color filters 180R and 180G and the encapsulation layer 182. The planarization layer 184 may be a transparent layer. In addition, the microlenses 180 may be disposed on the planarization layer 184 to correspond to the wavelength conversion units 160R, 160G, and 160B, respectively. The microlenses 180 may converge light incident from the wavelength conversion units 160R, 160G, and 160B. The microlenses 180 may have a diameter greater than a width of each of the LED cells LC, for example, in the X-direction and the Y-direction. The microlenses 180 may be formed of, for example, a transparent photoresist material or a transparent thermosetting resin layer.

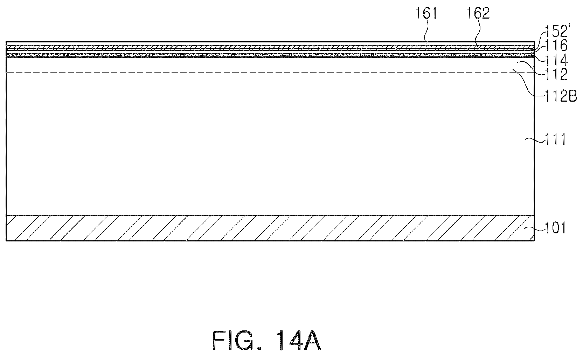

FIGS. 14A to 14I are cross-sectional views of main processes in a method of manufacturing of a display apparatus according to one or more example embodiments of the present disclosure.

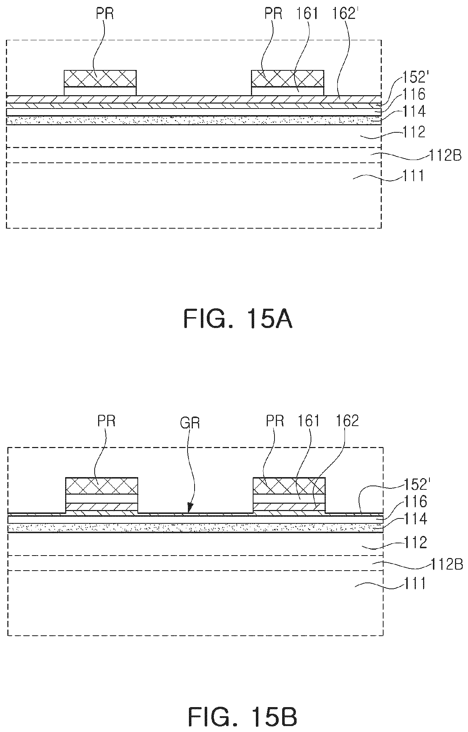

FIGS. 15A to 15L are cross-sectional views of the main processes of FIGS. 14A to 14F.

Referring to FIG. 14A, a semiconductor underlayer 111, a first conductivity-type semiconductor base layer 112B, a first conductivity-type semiconductor layer 112, an active layer 114, and a second conductivity-type semiconductor layer 116 may be sequentially formed on a growth substrate 101. Thus, a contact electrode layer 152', a cover electrode layer 162', and a hard mask layer 161' may be sequentially formed on the second conductivity-type semiconductor layer 116.

The growth substrate 101 may be a substrate for nitride single crystal growth, and may include at least one of sapphire, Si, SiC, MgAl₂O₄, MgO, LiAlO₂, LiGaO₂, and GaN. The semiconductor underlayer 111, the first conductivity-type semiconductor base layer 112B, the active layer 114, and the second conductivity-type semiconductor layer 116 may be formed using, for example, a metal organic chemical vapor deposition (MOCVD) process, a hydrogenated vapor epitaxy (HVPE) process, or a molecular beam epitaxy (MBE) process.

In some example embodiments, the semiconductor underlayer 111 may include a buffer layer and an undoped nitride layer (for example, GaN). The buffer layer may be provided to alleviate lattice defects of a first conductivity-type semiconductor cap layer 112, and may include an undoped nitride semiconductor such as undoped GaN, undoped AlN, and undoped InGaN. The first conductivity-type semiconductor base layer 112B and the first conductivity-type semiconductor layer 112 may be N-type nitride semiconductor layers such as N-type GaN. The first conductivity-type semiconductor base layer 112B may include high-concentration N-type GaN providing a contact region. The second conductivity-type semiconductor layer 116 may be a P-type nitride semiconductor layer such as P-type GaN/P-type AlGaN. The first to third active layers 114R, 114G, and 114B may have a single quantum well structure such as InGaN/GaN or a multiple quantum well structure.

The contact electrode layer 152', the cover electrode layer 162', and the hard mask layer 161' may be formed using a deposition process such as physical vapor deposition (PVD) or chemical vapor deposition (CVD). The contact electrode layer 152' may include a transparent electrode or a highly reflective ohmic contact layer. The cover electrode layer 162' may include a highly reflective material, for example, Ag, Al, Au, Rh, or the like. The hard mask layer 161' may include an insulating material such as SiO₂. In some example embodiments, a metal thin film may be further formed on the hard mask layer 161' for reasons such as adhesion between the hard mask layer 161' and a photoresist, deformation prevention of the hard mask layer 161', or the like.

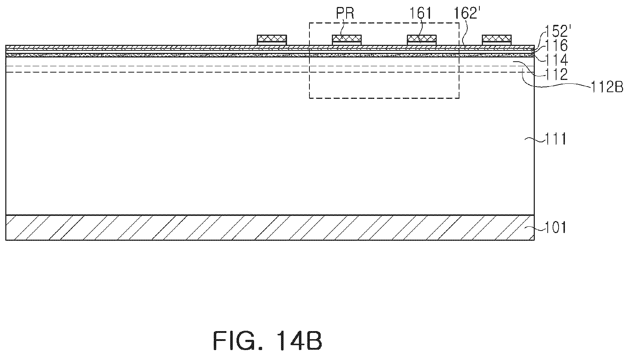

Referring to FIGS. 14B and 15A, a first capping layer 161 may be formed. The first capping layer 161 may be formed by removing a portion of the hard mask layer 161' using a dry etching process using a patterned photoresist PR. The first capping layer 161 may be formed to have an upwardly inclined side surface. The cover electrode layer 162' may include a material having etch selectivity with respect to the hard mask layer 161'.

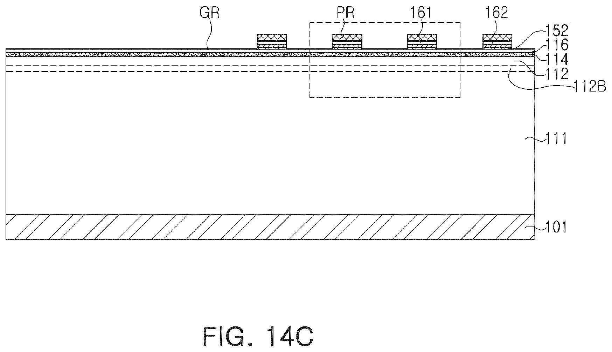

Referring to FIGS. 14C and 15B, a cover electrode 162 may be formed. The cover electrode 162 may be formed by removing a portion of the cover electrode layer 162' using a dry etching process using the photoresist PR and the first capping layer 161. The cover electrode 162 may be formed to have an upwardly inclined side surface. The dry etching process performed on the cover electrode layer 162' may be stopped after a portion of the contact electrode layer 152' is removed. The dry etching process performed on the cover electrode layer 162' may be performed using the contact electrode layer 152.' In this case, the contact electrode layer 152' may serve as an etching stopper during the dry etching process. As a result, a groove region GR may be formed in a portion of the contact electrode layer 152' positioned between the cover electrodes 162.

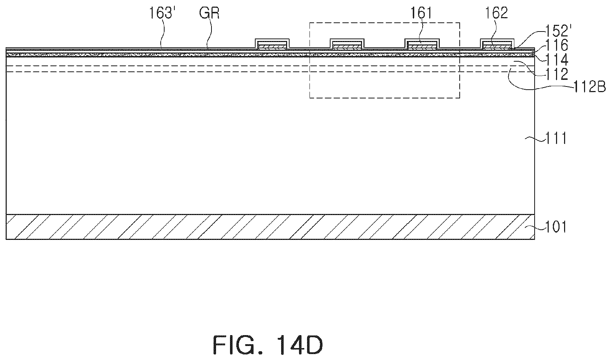

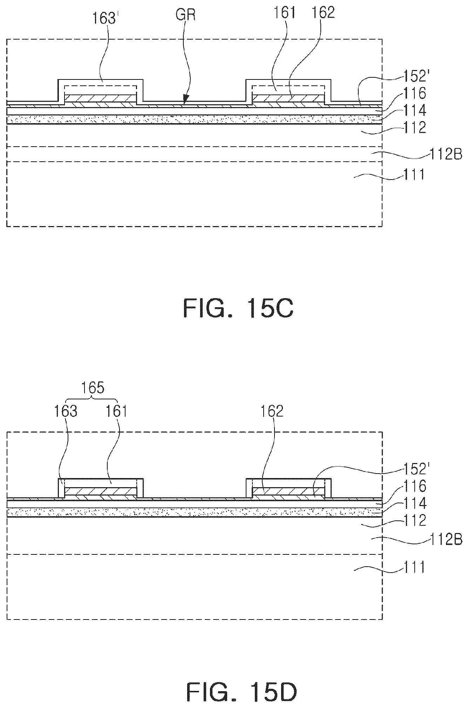

Referring to FIGS. 14D and 15C, an insulating liner 163' may be formed after the photoresist PR is removed. The insulating liner 163' may be formed using atomic layer deposition (ALD). The insulating liner 163' may be conformally formed on the groove region GR of the contact electrode layer 152' and surfaces of the cover electrode 162 and the first capping layer 161. The insulating liner 163' may include a material, similar to or the same as that of the first capping layer 161.

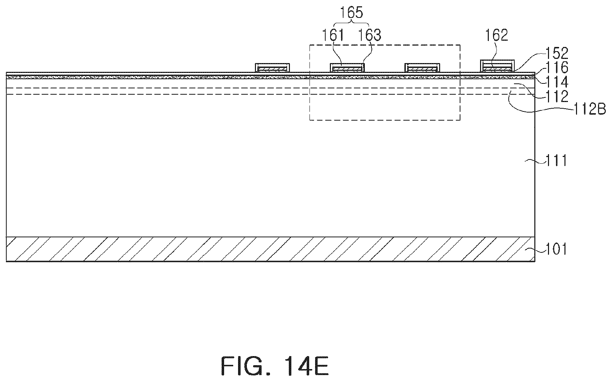

Referring to FIGS. 14E and 15D, a second capping layer 163 may be formed. The second capping layer 163 may be formed by partially removing the insulating liner 163' using a dry etching process. The second capping layer 163 may cover a side surface of the first capping layer 161, a side surface of the cover electrode 162, and a portion of a side surface of the groove region GR. The first capping layer 161 and the second capping layer 163 may prevent damage to the cover electrode 162 in a subsequent process. The second capping layer 163 may have an upwardly inclined external surface.

Referring to FIGS. 14F and 15E, a contact electrode 152 and LED cells LC1, LC2, and LC3 may be formed. The contact electrode 152 and the LED cells LC1, LC2, and LC3 may be formed by etching a multilayer structure of the first conductivity-type semiconductor layer 112, the active layer 114, the second conductivity-type semiconductor layer 116, and the contact electrode layer 152'. The contact electrode 152 may be formed on the second conductivity-type semiconductor layer 116. The contact electrode 152 may include a peripheral portion 152b defining a groove region GR surrounding a central portion 152a. The LED cells LC1, LC2, and LC3 may be formed using a dry etching process using the capping layer 165 as a mask. In this process, the LED cells LC1, LC2, and LC3 may have a damaged region DR in which a crystal defect occurs.

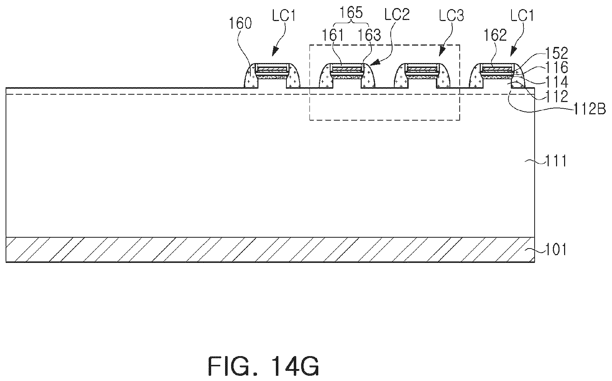

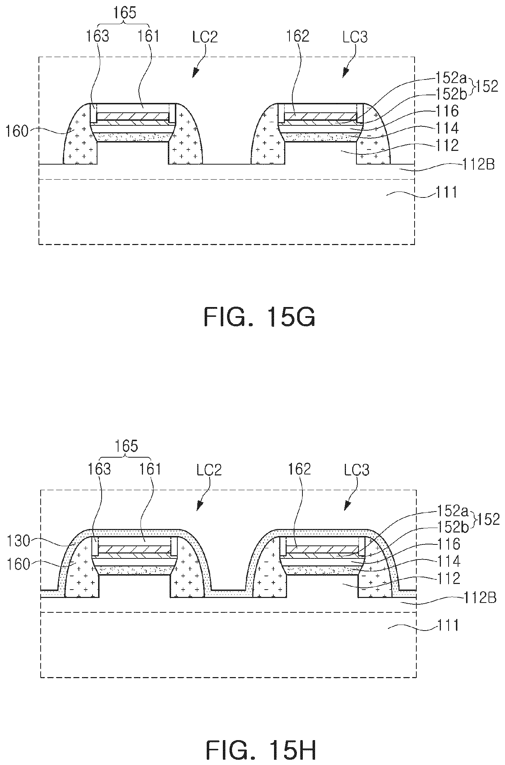

Referring to FIGS. 14G, 15F, and 15G, the damaged regions DR of the LED cells LC1, LC2, and LC3 may be removed, and then, a spacer 160, covering the LED cells LC1, LC2, and LC3 from which the damaged regions DR are removed, may be formed. The damaged regions DRs may be selectively removed using, for example, wet etching. As a result, non-radiant recombination caused by the damaged regions DRs may be reduced, thereby improving luminance. The first conductivity-type semiconductor layer 112, the active layer 114, and the second conductivity-type semiconductor layer 116 may be etched to have different widths due to an etching speed difference. For example, an average width of the active layer 114 may be less than an average width of the second conductivity-type semiconductor layer 116, and an average width of the first conductivity-type semiconductor layer 112 may be less than an average width of the active layer 114. The spacers 160 may be formed to surround side surfaces of a plurality of LED cells LC1, LC2, and LC3. The spacers 160 may be formed using a deposition process, an anisotropic etching process, an etch-back process, or the like.

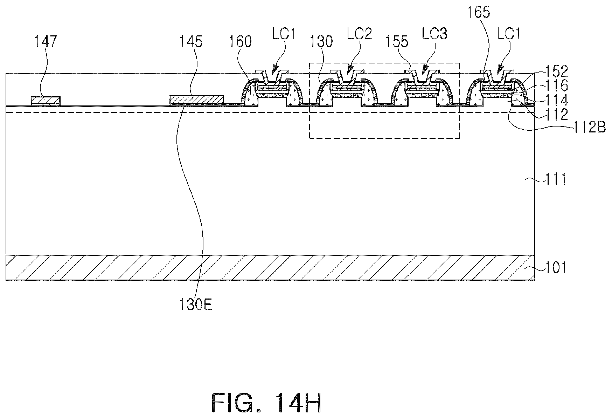

Referring to FIGS. 14H and 15H to 15L, a reflective electrode 130 may be formed on each of the LED cells LC1, LC2, and LC3, and a common electrode 145 and a pad electrode 147 may be formed. Subsequently, a gap-fill insulating layer 141 may be formed, and connection electrodes 155, connected to the cover electrodes 162, may be formed.

First, the reflective electrode 130 may be formed on the spacers 160 and a region of the first conductivity-type semiconductor base layer 112B between the spacers 160 (see FIG. 15H). The reflective electrode 130 may have a bowl-shaped reflective structure along an inclined outer sidewall of the spacer 160. The reflective electrode 130 may be electrically connected to a region of the first conductivity-type semiconductor base layer 112B between the plurality of LED cells LC1, LC2, and LC3. Subsequently, the common electrode 145 may be connected to the first conductivity-type semiconductor base layer 112B. The common electrode 145 may be formed on an extension portion 130E of the reflective electrode 130. The common electrode 145 and the pad electrode 147 may be formed together using the same process.

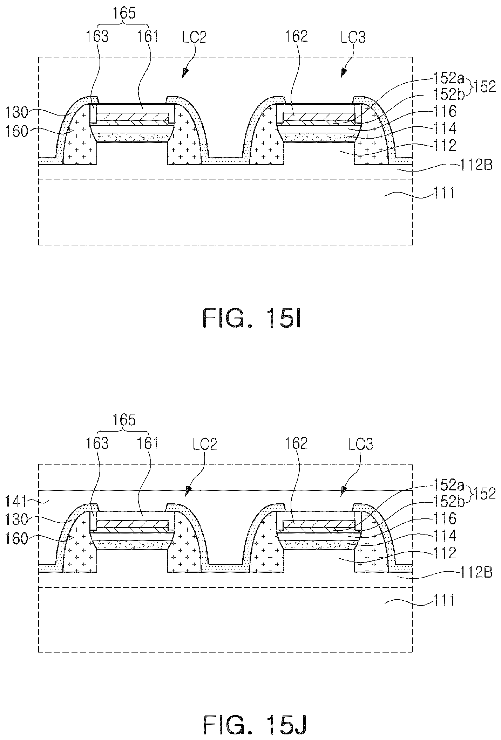

Subsequently, portions of the reflective electrode 130, positioned on upper portions of the plurality of LED cells LC1, LC2, and LC3, may be removed (see FIG. 15I). Regions in which the reflective electrode is partially removed may be provided as a path through which a second electrode structure is to be formed. Subsequently, the gap-fill insulating layer 141 may be formed to cover upper portions of the plurality of LED cells LC1, LC2, and LC3 on which the reflective electrode 130 is formed, and then a process of planarizing the gap-fill insulating layer 141 may be performed using a planarization process such as a chemical mechanical polishing (CMP) process or an etch-back process (see FIG. 15J). For example, the gap-fill insulating layer 141 may be a low-κ material such as silicon oxide.

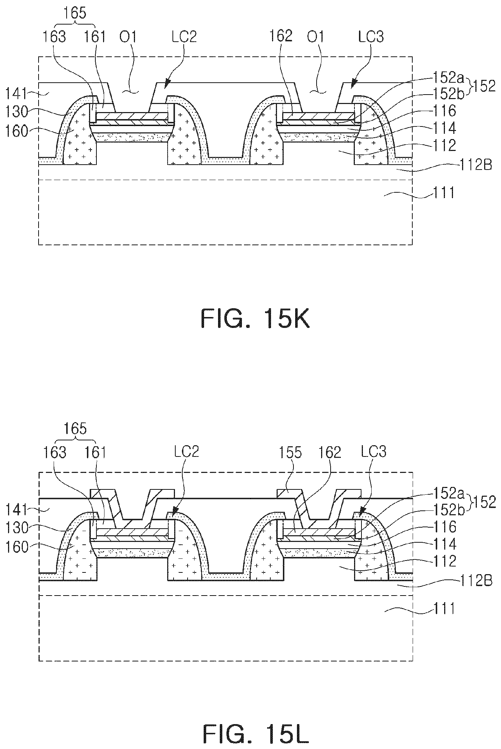

Subsequently, contact holes O1 may be formed to pass through the gap-fill insulating layer 141 and to respectively open the cover electrodes 162 (see FIG. 15K), and the connection electrodes 155 may be formed on the gap-fill insulating layer 141 to fill the contact holes O1 with a conductive material (see FIG. 15L). The connection electrodes 155 may be connected to the contact electrodes 152 through the contact hole O1, respectively.

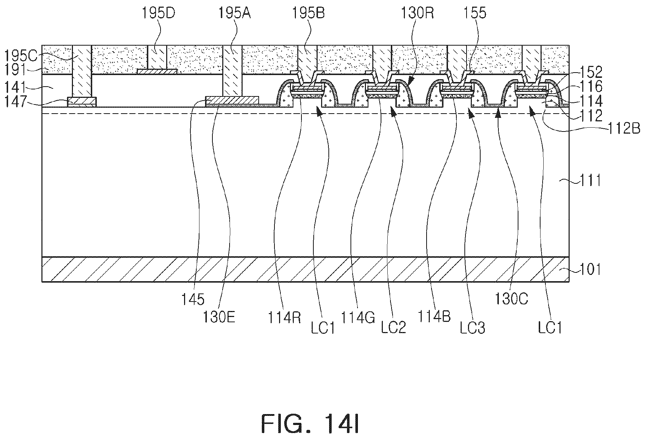

Referring to FIG. 14I, an upper bonding insulating layer 191 and upper bonding electrodes 195A, 195B, 195C and 195D may be formed. The upper bonding electrodes 195A, 195B, 195C and 195D may be formed by forming via holes passing through the upper bonding insulating layer 191 and/or the gap-fill insulating layer 141 and then filling the via holes with a conductive material. The upper bonding electrodes 195A, 195B, 195C and 195D may be formed to be connected to the connection electrodes 155, the common electrode 145, and the pad electrode 147.

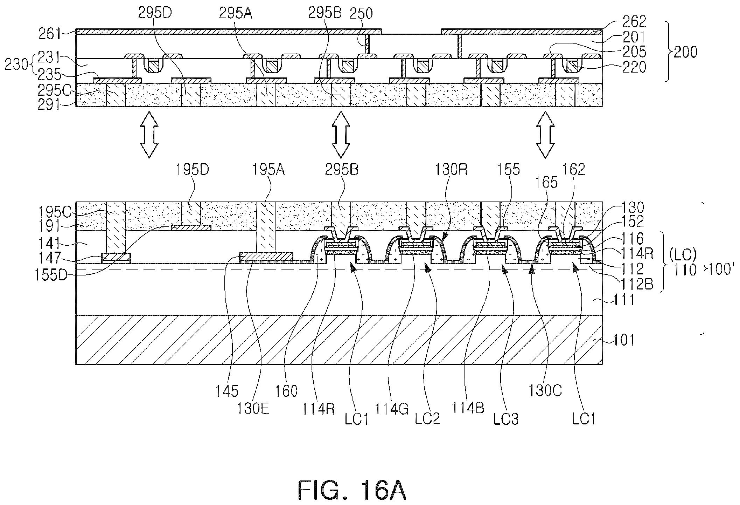

FIGS. 16A to 16C are cross-sectional views of main processes in a method of manufacturing of a display apparatus according to one or more example embodiments of the present disclosure.

Referring to FIG. 16A, a pixel array structure 100' including first to third LED cells LC1, LC2, and LC3 may be bonded to a circuit board 200. The circuit board 200 may be prepared using a process. The pixel array 100' and the circuit board 200 may be bonded to each other at a wafer level using a wafer bonding method, for example, hybrid bonding described above. As described above, the circuit board 200 may include a lower bonding insulating layer 291 and lower bonding electrodes 295A, 295B, 295C, and 295D. The lower bonding electrodes 295A, 295B, 295C, and 295D may be bonded to upper bonding electrodes 195A, 195B, 195C, and 195D, and the lower bonding insulating layer 291 may be bonded to an upper bonding insulating layer 191. As described, the pixel array 100', including the LED cells LC1, LC2, and LC3, and the circuit board 200 may be bonded to each other without an adhesive layer.

Referring to FIG. 16B, a growth substrate 101 and a semiconductor underlayer 111 may be removed. The growth substrate 101 may be removed using various processes such as a laser lift-off process, a mechanical polishing process or a mechanical chemical polishing process, or an etching process. The semiconductor underlayer 111 may be partially removed, such that a thickness of the semiconductor under layer 111 may be reduced to a predetermined thickness using, for example, a polishing process such as a CMP process. After the semiconductor underlayer 111 is removed, a first conductivity-type semiconductor base layer 112B may be exposed.

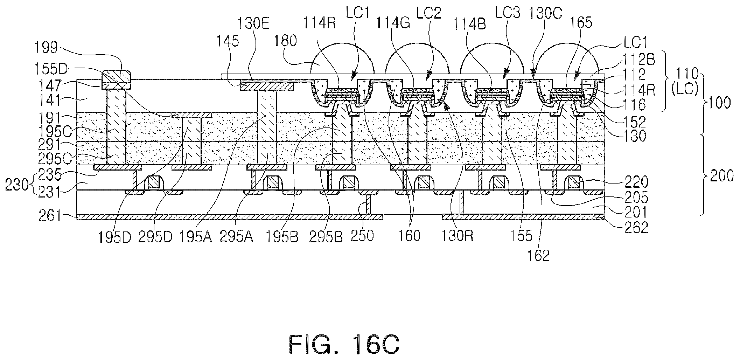

Referring to FIG. 16C, a first conductivity-type semiconductor base layer 112B, positioned in a pad region, may be further removed, and microlenses 180 and a bonding pad 199 may be further formed, thereby manufacturing the display apparatus 10 illustrated in FIGS. 3 to 4B.

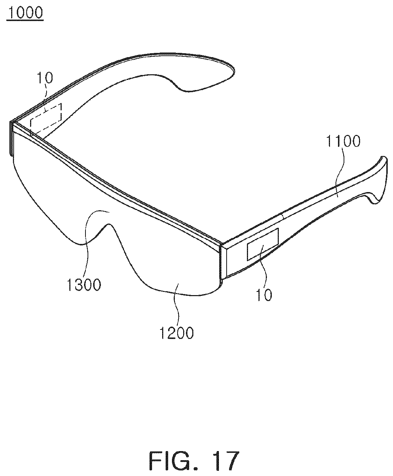

FIG. 17 is a schematic diagram of an electronic device 1000 including a display apparatus 10 according to one or more example embodiments of the present disclosure.

Referring to FIG. 17, an electronic device 1000 according to the present example embodiment may be a glasses-type display, a wearable device. The electronic device 1000 may include a pair of temples 1100, a pair of optical coupling lenses 1200, and a bridge 1300. The electronic device 1000 may further include a display apparatus 10 including an image generation unit.

The electronic device 1000 may be a head-mounted, glasses-type, or goggle-type virtual reality (VR) device, augmented reality (AR) device, or mixed reality (MR) device capable of providing virtual reality or providing both virtual images and actual external scenery.

Temples 1100 may extend in one direction. The temples 1100 may be spaced apart from each other, and may extend to be parallel to each other. The temples 1100 may be folded toward the bridge 1300 using a hinge connection unit. The bridge 1300 may be provided between the optical coupling lenses 1200 to connect the optical coupling lenses 1200 to each other. The optical coupling lenses 1200 may include a light guide plate. The display apparatus 10 may be disposed on each of portions of the temples 1100 adjacent to the optical coupling lenses 1200, and may generate an image on the optical coupling lenses 1200. In some example embodiments, the display apparatus 10 may be disposed in portions of the optical coupling lenses 1200.

According to example embodiments of the present disclosure, a display apparatus (10) having light emission efficiency may be provided by introducing a cover electrode (162) covering a transparent electrode (152) of each of micro-sized LED cells (LC1-LC3).

## Claims

1. A display apparatus (10) comprising:
a pixel array (100) in which pixel units (PX) are arranged, the pixel units (PX) respectively having a plurality of subpixels (SP1-SP3),
wherein the pixel array (100) includes:
a semiconductor stack (110) including a first conductivity-type semiconductor base layer (112B) having an upper surface provided as a light emitting surface, and a plurality of light emitting diode (LED) cells arranged on a lower surface of the first conductivity-type semiconductor base layer (112B), the plurality of LED cells (LC1-LC3) respectively having at least an active layer (114), a second conductivity-type semiconductor layer (116), and a transparent electrode (152), the transparent electrode (152) having a first lower surface (S1) and a second lower surface (S2) being offset from the first lower surface (S1) to form a step;
a cover electrode (162) stacked on the first lower surface (S1) of the transparent electrode (152) of each of the plurality of LED cells (LC1-LC3);
a capping layer (165) covering a lower surface of the cover electrode (162) and the second lower surface (S2) of the transparent electrode (152);
a reflective electrode (130) extending at least on a side surface of each of the plurality of LED cells (LC1-LC3); and
connection electrodes (155) electrically connected to the cover electrode (162) on each of the plurality of LED cells (LC1-LC3) through a contact hole of the capping layer (165).

2. The display apparatus (10) of claim 1, wherein the transparent electrode (152) comprises a central portion (152a) providing the first lower surface (S1), and a peripheral portion (152b) providing the second lower surface (S2), the peripheral portion (152b) surrounding the central portion (152a), and
a thickness (t1) of the central portion (152a) in a vertical direction (Z) is greater than a thickness (t2) of the peripheral portion (152b) in the vertical direction (Z).

3. The display apparatus (10) of claim 1 or 2, wherein a thickness (t3) of the cover electrode (162) in the vertical direction (Z) is greater than a thickness (t1) of the central portion (152a).

4. The display apparatus (10) of any one of claims 1 to 3, wherein the capping layer (165) comprises a first capping layer (161) vertically overlapping the cover electrode (162), and a second capping layer (163) extending along a side surface of the first capping layer (161) and a side surface of the cover electrode (162).

5. The display apparatus (10) of claim 4, wherein a thickness (t4) of the first capping layer (161) in a vertical direction (Z) is greater than a thickness (t5) of the second capping layer (163) in a horizontal direction (Y).

6. The display apparatus (10) of any one of claims 1 to 5, wherein a planar shape of the cover electrode (162) is equal to a planar shape of the transparent electrode (152) defined by the first lower surface (S1) and the second lower surface (S2).

7. The display apparatus (10) of any one of claims 1 to 6, wherein an area of the cover electrode (162) is greater than or equal to 60% of an area of the transparent electrode (152) defined by the first lower surface (S1) and the second lower surface (S2).

8. The display apparatus (10) of any one of claims 1 to 7, wherein the transparent electrode (152) includes a transparent conductive oxide, and
the cover electrode (162) comprises at least one of silver, Ag, nickel, Ni, aluminum, Al, chromium, Cr, rhodium, Rh,, iridium, Ir, palladium, Pd, ruthenium, Ru, magnesium, Mg, zinc, Zn, platinum, Pt, gold, Au, copper, Cu, titanium, Ti, tantalum, Ta, or tungsten, W.

9. The display apparatus (10) of claim 8, wherein the transparent conductive oxide comprises at least one of indium tin oxide, ITO, zinc indium tin oxide, ZITO, zinc indium oxide, ZIO, gallium indium oxide, GIO, zinc oxide, ZnO, zinc tin oxide, ZTO, fluorine-doped tin oxide, FTO, gallium tin oxide, GTO, aluminum-doped zinc oxide, AZO, or gallium-doped zinc oxide, GZO.

10. The display apparatus (10) of any one of claims 1 to 9, wherein the capping layer (165) comprises at least one of silicon monoxide, SiO, silicon nitride, SiN, silicon oxynitride, SiON, titanium monoxide, TiO, hafnium monoxide, HfO, aluminum nitride, AlN, aluminum oxide, AlO, or zirconium monoxide, ZrO.

11. The display apparatus (10) of any one of claims 1 to 10, wherein a width of the cover electrode (162) is greater than an upper width of the connection electrodes (155) in contact with the cover electrode (162), and is less than a width of the transparent electrode (152).

12. The display apparatus (10) of any one of claims 1 to 11, wherein the second conductivity-type semiconductor layer (116) and the active layer (114) are tapered upwardly, and
an average width of the second conductivity-type semiconductor layer (116) is greater than an average width of the active layer (114).

13. The display apparatus (10) of any one of claims 1 to 12, further comprising:
a spacer (160) covering the side surface of the plurality of LED cells (LC1-LC3), and comprising an inclined outer sidewall (160S),
wherein the reflective electrode (130) extends along the inclined outer sidewall (160S) of the spacer (160).

14. The display apparatus (10) of any one of claims 1 to 13,
wherein the first conductivity-type semiconductor base layer (112B) has a recess between the plurality of LED cells (LC1-LC3), and
the reflective electrode (130) is electrically connected to the first conductivity-type semiconductor base layer (112B) exposed to a bottom of the recess.

15. The display apparatus (10) of any one of claims 1 to 14,
wherein the first conductivity-type semiconductor base layer (112B) is provided as first conductivity-type semiconductor layers (112) stacked on the active layer (114) of each of the plurality of LED cells (LC1-LC3), the first conductivity-type semiconductor layers (112) separated from each other,
the reflective electrode (130) is provided as reflective electrodes (130) extending to the contact hole of the capping layer (165), the reflective electrodes (130) separated from each other, and
the connection electrodes (155) are electrically connected to the cover electrode (162) through the reflective electrodes (130) in the contact hole.
